# EUROPEAN PATENT SPECIFICATION

(11) **EP 4 201 983 B1**
(45) Date of publication and mention of the grant of the patent: **09.09.2026**
(21) Application number: 22850566.5
(22) Date of filing: 17.05.2022
(51) Int. Cl.: C08J 5/18, C08G 73/10, C08L 79/08, C08K 5/521, G02B 1/04, C08K 5/523

(54) **POLYIMIDE-BASED POLYMER FILM, AND SUBSTRATE FOR DISPLAY DEVICE, AND OPTICAL DEVICE, EACH USING SAME**
POLYIMIDBASIERTER HARZFILM, SUBSTRAT FÜR EINE ANZEIGEVORRICHTUNG UND OPTISCHE VORRICHTUNG DAMIT
FILM POLYMÈRE À BASE DE POLYIMIDE, ET SUBSTRAT POUR DISPOSITIF D'AFFICHAGE, ET DISPOSITIF OPTIQUE, CHACUN UTILISANT LEDIT FILM

(30) Priority: 08.11.2021 KR 20210152513
(43) Date of publication of application: 28.06.2023
(73) Proprietor: LG CHEM, LTD., Yeongdeungpo-gu Seoul 07336 (KR)
(72) Inventor: KANG, Mi Eun, Daejeon 34122 (KR); HONG, Ye Ji, Daejeon 34122 (KR); PARK, Chan Hyo, Daejeon 34122 (KR); PARK, Hangah, Daejeon 34122 (KR); LEE, Min Wook, Daejeon 34122 (KR)
(74) Representative: Goddar, Heinz J.
(86) International application number: PCT/KR2022/007039
(87) International publication number: WO 2023/080369

(56) References cited:
- CN-A- 1 145 917
- CN-A- 112 778 551
- JP-A- 2020 012 103
- JP-A- 2021 152 173
- JP-A- H08 143 666
- KR-A- 20210 026 053
- KR-A- 20210 151 323
- US-A1- 2020 216 614
- DATABASE WPI Week 200059, Derwent World Patents Index; AN 2000-614214, XP002811039
- DATABASE WPI Week 201908, Derwent World Patents Index; AN 2019-01738K, XP002811040
- DATABASE CAPLUS 2012, ANONYMOUS: "Preparation and properties study of mPDA/ODPA-PI film", XP093064921, retrieved from STN Database accession no. 2013:362696

## Description

### [Technical Field]

The present disclosure relates to a polyimide-based resin film that can realize excellent optical characteristics and low retardation, a substrate for display device and an optical device using the same.

### [Background Art]

The display device market is rapidly changing based on flat panel displays (FPDs) that are easy to fabricate over a large area and can be reduced in thickness and weight. Such flat panel displays include liquid crystal displays (LCDs), organic light emitting displays (OLEDs), or electrophoretic devices (EPDs).

In line with recent efforts to further extend the application and use of flat panel displays, particular attention has focused on so-called flexible display devices in which flexible substrates are applied to flat panel displays. The application of such flexible display devices is particularly reviewed based on mobile devices such as smart phones and the application fields thereof are gradually extended.

In general, in manufacturing a flexible display device and an illumination device, a TFT device is manufactured by forming a multilayer inorganic film such as a buffer layer, an active layer, and a gate insulator on the cured polyimide.

However, the polyimide resin conventionally used has a large refractive index in the plane direction and exhibits a large difference from the refractive index in the thickness direction. Due to this, as the polyimide has anisotropic properties, there is a limit in that a light distortion phenomenon occurs and thus the visibility is greatly deteriorated.

In addition, the polyimide resin is colored brown or yellow due to its high aromatic ring density, and has low transmittance in the visible ray region, exhibits a yellow-based color, thereby lowering the light transmittance and having a large birefringence, which is limited in its use as an optical member.

Therefore, there is a demand for the development of a new polyimide that can satisfy excellent optical characteristics while reducing the difference in refractive index in the plane direction and the thickness direction and thus improving the visibility.

US 2020/216614 A1 discloses a polyimide film generated from a solution containing a polyamic acid in a high-boiling, aprotic solvent; wherein the polyamic acid comprises one or more tetracarboxylic acid components and one or more diamine components; and wherein at least one of the tetracarboxylic acid components is a quadrivalent organic group derived from a bent dianhydride or an aromatic dianhydride comprising -O-, -CO-, -NHCO-, -S-, -SO₂-, -CO-O-, or -CR₂- links, or a direct chemical bond between aromatic rings; and wherein at least one of the diamine components is a divalent organic group derived from a bent diamine or an aromatic diamine comprising the same links, or a direct chemical bond between aromatic rings; and wherein R is the same or different at each occurrence and is selected from the group consisting of H, F, alkyl, and fluoroalkyl.

JP 2000 159 887 A relates to a polyimide film produced from a polyamic acid obtained by reacting p-phenylenebis(trimellitic acid monoester anhydride), oxydiphthalic acid dianhydride, p-phenylenediamine, 4,4'-diaminodiphenyl ether and at least one acid dianhydride selected from the group consisting of pyromellitic dianhydride, 3,3',4,4'-benzophenonetetracarboxylic dianhydride and 3,3',4,4'-biphenyltetracarboxylic dianhydride in an organic solvent.

WO 2019/004 677 A1 relates to a polyimide precursor composition, a preparation method therefor, and a polyimide substrate manufactured therefrom.

### [DETAILED DESCRIPTION OF THE INVENTION]

### [Technical Problem]

It is an object of the present disclosure to provide a polyimide-based resin film that can achieve optical characteristics and low retardation.

It is another object of the present disclosure to provide a substrate for display device and an optical device using the polyimide-based resin film.

### [Technical Solution]

The invention is defined in the appended claims.

In order to achieve the above objects, one aspect of the present disclosure provides a polyimide-based resin film in which a refractive index difference (Δn) obtained by the following Equation 1 is 0.0068 or less, and a yellow index at a thickness of 10 µm is 5.5 or less as measured using a color meter: $Refractive Index Difference \left(Δn\right) = n 1 - n 2$
wherein, in Equation 1, n1 is a plane direction refractive index value of the polyimide-based resin film at a thickness of 10 µm, and n2 is a thickness direction refractive index value of the polyimide-based resin film at a thickness of 10 µm as both measured at a wavelength of 532 nm using a prism coupler,
wherein the polyimide-based resin film includes a polyimide-based resin containing a polyimide repeating unit represented by the following Chemical Formula 1 in an amount of 20 mol% to 100 mol% based on 100 mol% of the total repeating unit: 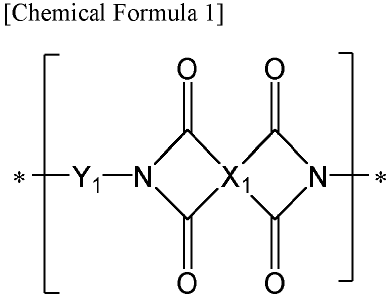
wherein, in Chemical Formula 1,
X₁ includes a tetravalent functional group represented by the following Chemical Formula 2: 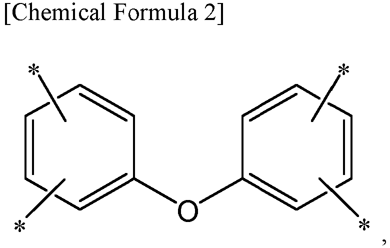 and
Y₁ includes a functional group represented by the following Chemical Formula 3-1: 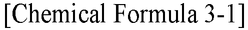 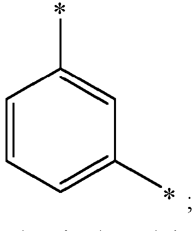 and
wherein the polyimide-based resin film includes a triaryl phosphate.

Another aspect of the present disclosure provides a substrate for display device comprising the polyimide-based resin film.

A further aspect of the present disclosure provides an optical device comprising the polyimide-based resin film.

Hereinafter, a polyimide-based resin film according to specific embodiments of the present disclosure, a substrate for a display device and an optical device using the same will be described in more detail.

The singular forms "a", "an", and "the" used herein include plural references unless the context clearly dictates otherwise.

The term "including" or "comprising" used herein specifies a specific feature, region, integer, step, action, element and/or component, but does not exclude the presence or addition of a different specific feature, region, integer, step, action, element, component and/or group.

The terms including ordinal numbers such as "a first", "a second", etc. are used only for the purpose of distinguishing one component from another component, and are not limited by the ordinal numbers. For instance, a first component may be referred to as a second component, or similarly, the second component may be referred to as the first component, without departing from the scope of the present invention.

In the present specification, the (co)polymer means including both a polymer and a copolymer, the polymer means a homopolymer consisting of a single repeating unit, and the copolymer means a composite polymer containing two or more repeating units.

In the present specification, examples of the substituents are described below, but are not limited thereto.

In the present specification, the term "substituted" means that other functional groups instead of a hydrogen atom in the compound are bonded, and a position to be substituted is not limited as long as the position is a position at which the hydrogen atom is substituted, that is, a position at which the substituent can be substituted, and when two or more are substituted, the two or more substituents may be the same as or different from each other.

In the present specification, the term "substituted or unsubstituted" means being unsubstituted or substituted with one or more substituents selected from the group consisting of deuterium; a halogen group; a cyano group; a nitro group; a hydroxyl group; a carbonyl group; an ester group; an imide group; an amide group; a primary amino group; a carboxy group; a sulfonic acid group; a sulfonamide group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkoxysilylalkyl group; an arylphosphine group; or a heterocyclic group containing at least one of N, O, and S atoms, or being unsubstituted or substituted with a substituent to which two or more substituents are linked among the substituents exemplified above. For example, "the substituent to which two or more substituents are linked" may be a biphenyl group. That is, the biphenyl group may also be an aryl group, and may be interpreted as a substituent to which two phenyl groups are linked. In the present specification, the notation 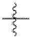 , or -* means a bond linked to another substituent group, and a direct bond means the case where no other atoms exist in the parts represented as L.

In the present specification, aromatic is a property that satisfies Huckle's Rule, and a compound can be defined as aromatic if all of the following three conditions are satisfied according to Huckle's Rule.
1) There must be 4n+2 electrons that are completely conjugated by empty p-orbitals, unsaturated bonds, lone electron pairs, etc.
2) 4n+2 electrons have to form planar isomers and form a ring structure.
3) All atoms of the ring have to be able to participate in conjugation.

In the present specification, a multivalent functional group is a residue in which a plurality of hydrogen atoms bonded to an arbitrary compound are removed, and for example, it may be a divalent functional group, a trivalent functional group, and a tetravalent functional group. As an example, a tetravalent functional group derived from a cyclobutane means a residue in which any four hydrogen atoms bonded to the cyclobutane are removed.

In the present specification, the aryl group is a monovalent functional group derived from an arene, and is not particularly limited, but the carbon number thereof is preferably 6 to 20, and it may be a monocyclic aryl group or a polycyclic aryl group. The monocyclic aryl group may be a phenyl group, a biphenyl group, a terphenyl group or the like, but is not limited thereto. The polycyclic aryl group includes a naphthyl group, an anthracenyl group, a phenanthrenyl group, a pyrenyl group, a perylenyl group, a chrysenyl group, or the like, but is not limited thereto. The aryl group may be substituted or unsubstituted, and when it is substituted, examples of the substituent are the same as described above.

In the present specification, a direct bond or a single bond means being connected to a bond line in which no atoms or atomic groups exist at the corresponding position. Specifically, it means the case where no other atoms exist in the parts represented as L₁, or L₂ in Chemical Formula.

In the present specification, the weight average molecular weight means a weight average molecular weight in terms of polystyrene measured by GPC method. In the process of determining the weight average molecular weight in terms of polystyrene measured by the GPC method, a commonly known analyzing device, a detector such as a refractive index detector, and an analytical column can be used. Commonly applied conditions for temperature, solvent, and flow rate can be used. Specifically, the measurement was performed, for example, using Waters PL-GPC220 and a Polymer Laboratories PLgel MIX-B 300 mm length column. An evaluation temperature was 160°C, 1,2,4-trichlorobenzene was used as a solvent, and the flow rate is 1 mL/min. The sample at a concentration of 10 mg/10 mL was supplied in an amount of 200 µL, and the values of Mw were obtained using a calibration curve formed using a polystyrene standard. 9 kinds of the polystyrene standards were used with the molecular weight of 2,000 / 10,000 / 30,000 / 70,000 / 200,000 / 700,000 / 2,000,000 / 4,000,000 / 10,000,000.

Now, the present disclosure will be described in more detail.

### 1. Polyimide-based resin film

According to one embodiment of the present disclosure, there can be provided a polyimide-based resin film in which a refractive index difference (Δn) obtained by the following Equation 1 is 0.0068 or less, and a yellow index at a thickness of 10 µm is 5.5 or less as measured using a color meter: $Refractive Index Difference \left(Δn\right) = n 1 - n 2$
wherein, in Equation 1, n1 is a plane direction refractive index value of the polyimide-based resin film at a thickness of 10 µm, and n2 is a thickness direction refractive index value of the polyimide-based resin film at a thickness of 10 µm as both measured at a wavelength of 532 nm using a prism coupler,
wherein the polyimide-based resin film includes a polyimide-based resin containing a polyimide repeating unit represented by the following Chemical Formula 1 in an amount of 20 mol% to 100 mol% based on 100 mol% of the total repeating unit: 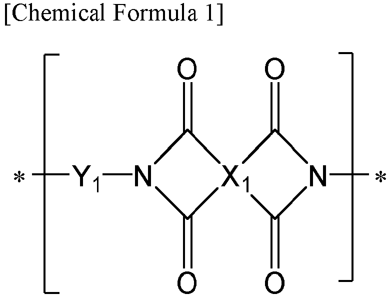
wherein, in Chemical Formula 1,
X₁ includes a tetravalent functional group represented by the following Chemical Formula 2: 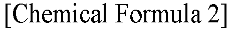 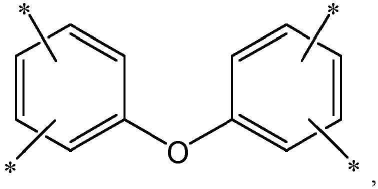 and
Y₁ includes a functional group represented by the following Chemical Formula 3-1: 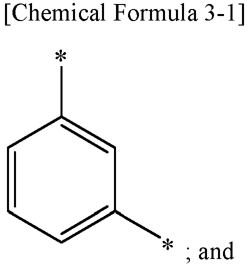
wherein the polyimide-based resin film includes a triaryl phosphate.

The present inventors have found through experiments that when the refractive index difference (Δn) obtained by Equation 1 is 0.0068 or less and the yellow index at a thickness of 10 µm satisfies 5.5 or less as in the polyimide-based resin film of the one embodiment, the light transmittance is increased through low yellow index and significantly improved transparency, resulting in low birefringence, which is suitable for use as an optical member, and at the same time, the optical isotropy is increased through a low refractive index difference (Δn) characteristic to realize a low retardation, thereby securing a diagonal viewing angle of the display to which the polyimide-based resin film is applied, and preventing deterioration of visibility due to the light distortion phenomenon, and completed the present disclosure.

Specifically, the polyimide-based resin film according to the present disclosure can increase the refractive index and is used as a substrate layer in a flexible display device, and can reduce the difference in refractive index from each layer constituting the device, thereby reducing the amount of light that is extinguished inside, and effectively increasing the bottom emission efficiency.

Specifically, the polyimide-based resin film of the one embodiment has a refractive index difference (Δn) obtained by the following Equation 1 of 0.0068 or less, or 0.0065 or less, or 0.0050 or less, or 0.0010 or more, or 0.0010 to 0.0068, or 0.0010 to 0.0065, or 0.0010 to 0.0050, or 0.0034 to 0.0045, or 0.0044 to 0.0067. In this manner, as the refractive index difference (Δn) is smaller, it has a lower retardation, thus capable of realizing excellent visibility. $Refractive Index Difference \left(Δn\right) = n 1 - n 2$ wherein, in Equation 1, n1 is a plane direction refractive index value of the polyimide-based resin film at a thickness of 10 µm, and n2 is a thickness direction refractive index value of the polyimide-based resin film at a thickness of 10 µm.

More specifically, in Equation 1, the plane direction refractive index at a wavelength of 532 nm corresponding to n1 may be 1.70 to 1.71, or 1.7019 to 1.7066, or 1.7039 to 1.7066, or 1.7019 to 1.7042. Further, in Equation 1, the thickness direction refractive index at a wavelength of 532 nm corresponding to n2 may be 1.69 to 1.71, or 1.6957 to 1.7029, or 1.7 to 1.7029, or 1.6957 to 1.6993. That is, in Equation 1, n1 and n2 may each satisfy the above-mentioned range and simultaneously satisfy the refractive index difference (Δn) range of Equation 1 above.

Such a small refractive index difference (Δn) appears to be achieved by reducing the refractive index difference between the plane direction and the thickness direction using, as a monomer used in the production of polyimide-based resin films, m-phenylenediamine (m-PDA) which is a diamine with an asymmetric structure, and 4,4'-oxydiphthalic anhydride (ODPA) which is an anhydride having a bent-shaped folded structure, as will be described later.

Examples of the method and device for measuring the refractive index in the plane direction and the refractive index in the thickness direction are not particularly limited, and various methods conventionally used for measuring the refractive index can be applied without limitation. As an example, the refractive index in the plane direction and the refractive index in the thickness direction can be measured at a wavelength of 532 nm using a prism coupler.

The refractive index can be measured from the polyimide-based resin film sample having a thickness of 10±1 µm. When the thickness of the polyimide-based resin film increases or decreases by a specific numerical value, the physical properties measured from the polyimide-based resin film may also change by a certain numerical value.

When the refractive index difference (Δn) obtained by Equation 1 is excessively increased to more than 0.0068, or more than 0.0065, or more than 0.0050, there is a technical limit in that as the retardation increases, a distortion phenomenon occurs if light is transmitted at the time of implementing a transparent display, and the visibility is poor.

On the other hand, the polyimide-based resin film may have a yellow index at a thickness of 10 µm of 5.5 or less, or 4.3 or less, or 1.0 or more, or 1.0 to 5.5, or 1.0 to 4.3, or 1.91 to 5.23, or 3.03 to 4.16. When the yellow index at a thickness of 10 µm of the polyimide-based resin film is excessively increased to more than 5.5, or more than 4.3, or the like, there is a limit in that the degree of yellow discoloration of the polyimide-based resin film increases, which makes it difficult to produce a colorless and transparent film.

Such a low yellow index (YI) appears to be achieved by using, as the monomer used in the production of a polyimide-based resin film, m-phenylenediamine (m-PDA) which is a diamine with an asymmetric structure, and 4,4'-oxydiphthalic anhydride (ODPA) which is an anhydride having an ether group as an electron-withdrawing functional group and having a bent structure.

More specifically, in the case of a polyimide having a planar linear main-chain structure, the polyimides are packed side by side and stacked, while the polyimide having a bent main-chain structure is not packed well between molecules, whereby transparency can be secured by suppressing CTC, and the effect of suppressing CTC can be enhanced due to the electron withdrawing effect by the ether group.

Examples of the method and device for measuring the yellow index of the one embodiment are not particularly limited, and various methods conventionally used for measuring the YI can be applied without limitation. As an example, it can be measured using a color meter (Color-Eye 7000A produced by GRETAGMACBETH).

The yellow index can be measured from the polyimide-based resin film sample having a thickness of 10±1 µm. When the thickness of the polyimide-based resin film increases or decreases by a specific numerical value, the physical properties measured from the polyimide-based resin film may also change by a certain numerical value.

On the other hand, the polyimide-based resin film of the one embodiment has a color coordinate b* at a thickness of 10 µm of 1 to 4, or 1 to 3.3, or 1 to 3.2, or 1 to 3.1, or 1.19 to 3.60, or 1.62 to 2.95. In this manner, as the color coordinate b* becomes lower, the polyimide-based resin film of the one embodiment has lower yellowing characteristics and thus can realize excellent optical characteristics.

As used herein, the "color coordinates" means coordinates in the CIE Lab color space, which are color values defined by CIE (Commossion International de l'Eclairage), and an arbitrary position in the CIE color space may be represented by three coordinate values L*, a*, and b*.

Wherein, the L* value represents brightness. If L*=0, it represents black, and if L*=100, it represents white. Further, the a* value indicates which way the color having the corresponding color coordinate is biased between pure red and pure green, and the b* value indicates which way the color having the corresponding color coordinate is biased between pure yellow and pure blue.

Specifically, the a* value has a range from -a to +a. The maximum value of a* (a* max) represents pure red, and the minimum value of a* (a* min) represents pure green. Further, the b* value has a range from -b to +b. The maximum value of b* (b* max) represents pure yellow, and the minimum value of b* (b* min) represents pure blue. For example, if the b * value is negative, it means a color biased towards pure blue, and if the value is positive, it means a color biased toward pure yellow. Comparing b*=50 and b*=80, it means that b*=80 is closer to pure yellow than b*=50.

Examples of the method and device for measuring color coordinates are not specifically limited, and various methods conventionally used for measuring color coordinates can be applied without limitation. As an example, the color coordinate (b*) can be measured for the polyimide-based resin film using a color meter (Color-Eye 7000A produced by GRETAGMACBETH).

The color coordinate (b*) can be measured from the polyimide-based resin film sample having a thickness of 10±1 µm. When the thickness of the polyimide-based resin film increases or decreases by a specific numerical value, the physical properties measured from the polyimide-based resin film may also change by a certain numerical value.

When the color coordinate b* at a thickness of 10 µm of the polyimide-based resin film is excessively increased to more than 4, or more than 3.3, or more than 3.2, or more than 3.1, there is a limit that it is difficult to apply as a display because the color coordinates of the polyimide-based resin film are misaligned and the color distortion phenomenon occurs.

Meanwhile, the polyimide-based resin film may have a haze value of less than 1.0%, or 0.1% or more and less than 1.0%. The haze can be measured from the polyimide-based resin film sample having a thickness of 10±1 µm. When the thickness of the polyimide-based resin film increases or decreases by a specific numerical value, the physical properties measured from the polyimide-based resin film may also change by a certain numerical value.

Further, the polyimide-based resin film of the one embodiment may have a thickness direction retardation value at a thickness of 10 µm of 10 nm to 52 nm, or 10 nm to 50 nm, or 10 nm to 45 nm, or 10 nm to 40 nm, or 10 nm to 35 nm, or 20 nm to 35 nm, or 27 nm to 52 nm. In this manner, the optical isotropy is increased through the low retardation (Rₜₕ) characteristic in the thickness direction, and thus, the diagonal viewing angle of the display to which the polyimide-based resin film is applied can be secured to realize excellent visibility.

Such a low retardation appears to be achieved by reducing the refractive index difference between the plane direction and the thickness direction, using, as the monomer used in the production of polyimide-based resin films, m-phenylenediamine (m-PDA) which is a diamine with an asymmetric structure, and 4,4'-oxydiphthalic anhydride (ODPA) which is an anhydride with a bent structure, as will be described later.

More specifically, in the case of a polyimide having a planar linear main-chain structure, the refractive index in the thickness direction is low because polyimides are packed side by side and stacked, while the refractive index in the thickness direction may increase because polyimide with a bent main-chain structure is not packed molecules well.

The retardation in the thickness direction can be measured for a wavelength of 532 nm, and examples of the measuring method and device are not particularly limited, and various methods conventionally used for measuring the retardation in the thickness direction can be applied without limitation.

The retardation in the thickness direction may be measured from the polyimide-based resin film sample having a thickness of 10±1 µm. When the thickness of the polyimide-based resin film increases or decreases by a specific numerical value, the physical properties measured from the polyimide-based resin film may also change by a certain numerical value.

Specifically, the thickness direction retardation Rₜₕ can be calculated according to the following Equation 2. ${R}_{th} \left(nm\right) = \left|\left[\left({n}_{x}+{n}_{y}\right)/2\right]-{n}_{z}\right| \times d$ wherein, in Equation 2, nₓ is the largest refractive index among in-plane refractive indices of the polyimide resin film measured with light having a wavelength of 532 nm; n_{y} is a refractive index perpendicular to nₓ among in-plane refractive indices of the polyimide resin film measured with light having a wavelength of 532 nm; n_{z} is the thickness direction refractive index of the polyimide resin film measured with light having a wavelength of 532 nm; and d is the thickness of the polyimide-based resin film.

That is, the thickness direction retardation Rₜₕ is a value obtained by multiplying the film thickness by the absolute value of the difference between the thickness direction refractive index value (n_{z}) and the average value [(nₓ + n_{y})/2] of the in-plane refractive index value. As the difference between the thickness direction refractive index value n_{z} and the average value [(nₓ+n_{y})/2] of the in-plane refractive index values is smaller, it can exhibit the lower value.

As the polyimide-based resin film has the retardation value at a thickness of 10 µm of 10 nm to 52 nm, or 10 nm to 50 nm, or 10 nm to 45 nm, or 10 nm to 40 nm, or 10 nm to 35 nm, excellent visibility can be realized as the difference between the thickness direction refractive index value (n_{z}) and the average value of the plane refractive index value [(nx+ny)/2] decreases on the display to which the polyimide-based resin film is applied.

When the retardation value in the thickness direction of the polyimide-based resin film at a thickness of 10 µm is excessively increased to more than 52 nm, or more than 50 nm, or more than 45 nm, or more than 40 nm, or more than 35 nm, a distortion phenomenon occurs in a structure where polyimide exists on the upper part, when light is transmitted at the time implementing a transparent display. Thus, there is a technical limit in that the refraction of transmitted light cannot be corrected even with a compensation film that compensates up to 45 nm.

The polyimide-based resin film may have an average refractive index at a wavelength of 532 nm of 1.6995 to 1.7060, or 1.6998 to 1.7058, or 1.7028 to 1.7058, or 1.6998 to 1.7026. As an example of a method of measuring the average refractive index, the refractive indices in the plane direction (TE) and the thickness direction (TM) were measured at a wavelength of 532 nm using a prism coupler, and the average refractive index was calculated according to the following Equation 3. $Average refractive index = \left({n}_{x}+{n}_{y}+{n}_{z}\right) / 3$ wherein, in Equation 3, nₓ is the largest refractive index among in-plane refractive indices of the polyimide resin film measured with light having a wavelength of 532 nm; n_{y} is a refractive index perpendicular to nₓ among in-plane refractive indices of the polyimide resin film measured with light having a wavelength of 532 nm; and n_{z} is the thickness direction refractive index of the polyimide resin film measured with light having a wavelength of 532 nm.

The average refractive index can be measured from the polyimide-based resin film sample having a thickness of 10±1 µm. When the thickness of the polyimide-based resin film increases or decreases by a specific numerical value, the physical properties measured from the polyimide-based resin film may also change by a certain numerical value.

Meanwhile, the polyimide-based resin film includes a polyimide-based resin. The polyimide-based resin means including both a polyimide, and a precursor polymer thereof such as polyamic acid or polyamic acid ester. That is, the polyimide-based polymer may include one or more selected from the group consisting of a polyamic acid repeating unit, a polyamic acid ester repeating unit, and a polyimide repeating unit. That is, the polyimide-based polymer may include one type of polyamic acid repeating unit, one type of polyamic acid ester repeating unit, one type of polyimide repeating unit, or a copolymer in which these two or more types of repeating units are mixed.

The one or more repeating units selected from the group consisting of a polyamic acid repeating unit, a polyamic acid ester repeating unit, and a polyimide repeating unit may form a main chain of the polyimide-based polymer.

The polyimide-based resin film may include a cured product of the polyimide-based resin. The cured product of the polyimide-based resin means a product obtained through the curing process of the polyimide-based resin.

In particular, the polyimide-based resin includes a polyimide repeating unit represented by the following Chemical Formula 1 in an amount of 20 mol% to 100 mol% based on 100 mol% of the total repeating unit. 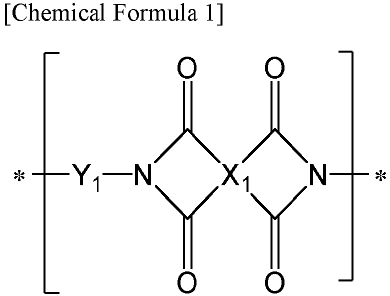
wherein, in Chemical Formula 1, X₁
includes a tetravalent functional group represented by the following Chemical Formula 2: 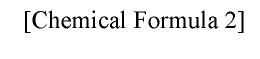 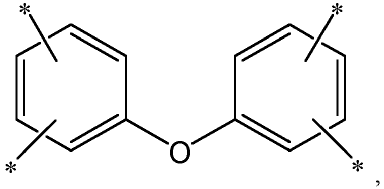 and
Y₁ includes a functional group represented by the following Chemical Formula 3-1:

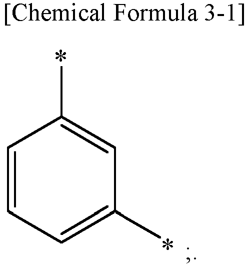

In Chemical Formula 1, X₁ is an aromatic tetravalent functional group containing an ether group, wherein the X₁ is a functional group derived from a tetracarboxylic dianhydride compound used in the synthesis of a polyimide-based resin.

When the aromatic tetravalent functional group containing the ether group is included in the X₁, as the structure in which the ether functional group and two benzene rings are bent in a bent form is introduced into the polyimide chain structure, packing between molecules is not performed well. Therefore, while the refractive index in the thickness direction increases, the low retardation can be realized by reducing the difference in refractive index between the plane direction and the thickness direction, and the formation of CTC (charge transfer complex) of Pi electrons existing in the imide chain can be suppressed due to the electron withdrawing effect of the ether group, thereby securing the transparency and realizing excellent optical properties.

Meanwhile, if a functional group derived from BPDA (3,3',4,4'-biphenyltetracarboxylic dianhydride), which does not contain an ether group, or PMDA (pyromellitic dianhydride) is included in the X₁, it is difficult to implement the structure bent in a curved shape and the transparency due to the above-mentioned ether group, which causes a problem that a difference in refractive index in a plane direction and a thickness direction can increase, and the yellow index also increases.

Specific examples of the functional group represented by Chemical Formula 2 may include a functional group represented by Chemical Formula 2-1 derived from 4,4'-oxydiphthalic Anhydride (ODPA).

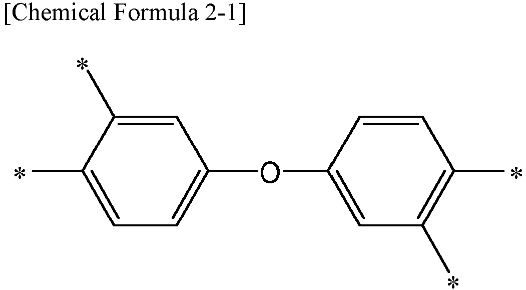

Meanwhile, in Chemical Formula 1, Y₁ is an aromatic divalent functional group represented by the following Chemical Formula 3-1 derived from m-phenylenediamine (1,3-phenylenediamine, m-PDA).

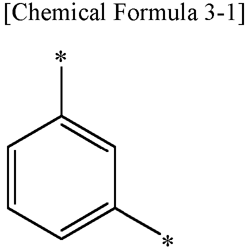

When the functional group represented by Chemical Formula 3-1 is included in Y₁, as the asymmetric structure is introduced into the polyimide chain structure in a curved form, the arrangement can be maintained in the thickness direction, so that a low retardation can be realized by reducing the difference in refractive index between the plane direction and the thickness direction.

On the other hand, when a functional group derived from p-phenylenediamine (1,4-phenylenediamine, p-PDA) having no curved asymmetric structure is included in the Y₁, it is difficult to implement the above-mentioned bent asymmetric structure, and thus, the polymer grows only in the plane direction while the polyimide is polymerized in a linear direction in the plane. Therefore, as the polymers are well packed, the refractive index in the thickness direction decreases, which may cause a problem that the difference in refractive index in the plane direction and in the thickness direction increases.

Further, when the functional group derived from 4,4'-oxydianiline (ODA) is included in the Y₁, due to the symmetric structure, the refractive index in the thickness direction decreases as the polymers are well packed, which may cause a problem that the difference in refractive index between the plane direction and the thickness direction increases.

The polyimide-based resin may include a combination of an aromatic tetracarboxylic dianhydride containing an ether group and an aromatic diamine having 6 to 10 carbon atoms.

The aromatic tetracarboxylic dianhydride containing an ether group is a compound in which an anhydride group (-OC-O-CO-) is introduced at both ends of the aromatic tetravalent functional group containing an ether group, and the details of the aromatic tetravalent functional group containing an ether group are the same as described above.

Specific examples of the ether group-containing aromatic tetracarboxylic dianhydride include 4,4'-oxydiphthalic anhydride (ODPA).

The aromatic diamine having 6 to 10 carbon atoms is a compound in which amino groups (-NH₂) are introduced at both ends of the aromatic divalent functional group having 6 to 10 carbon atoms, and details of the aromatic divalent functional group having 6 to 10 carbon atoms are the same as described above.

Specific examples of the aromatic diamine having 6 to 10 carbon atoms include m-phenylenediamine (1,3-phenylenediamine, m-PDA).

More specifically, in the polyimide-based resin, a bond between the nitrogen atom of the amino group and the carbon atom of the anhydride group is formed by a reaction between the terminal anhydride group (-OC-O-CO-) of the aromatic tetracarboxylic acid dianhydride containing the ether group and the terminal amino group (-NH₂) of the aromatic diamine having 6 to 10 carbon atoms.

Meanwhile, the polyimide-based resin may further include a polyimide repeating unit represented by the following Chemical Formula 4 in addition to the polyimide repeating unit represented by Chemical Formula 1. That is, the polyimide-based resin may include a polyimide repeating unit represented by Chemical Formula 1 and a polyimide repeating unit represented by Chemical Formula 4. 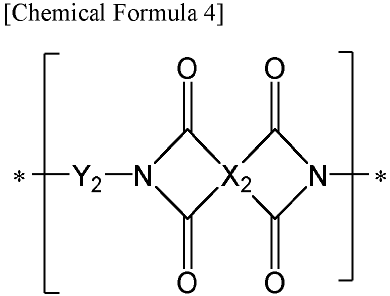 wherein, in Chemical Formula 4, X₂ is an aromatic tetravalent functional group containing an ether group, and Y₂ is an aromatic divalent functional group containing an ether group and having 12 to 17 carbon atoms.

The X₂ is the same as X₁ of Chemical Formula 1.

The aromatic divalent functional group having 12 to 17 carbon atoms and containing the ether group may include a functional group represented by the following Chemical Formula 5 derived from 4,4'-oxydianiline (ODA).

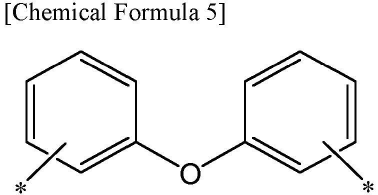

When the functional group represented by Chemical Formula 5 is included in the Y₂, the formation of the charge transfer complex (CTC) of Pi-electrons in the imide chain is suppressed due to the electron withdrawing effect by the ether group, thereby capable of securing transparency and further realizing optical properties. In addition, since the functional group represented by Chemical Formula 5 also has a bent structure, it is possible to suppress an increase in the refractive index difference between the plane direction and the thickness direction while maintaining a small refractive index in the thickness direction, thereby maintaining a low retardation.

That is, the polyimide-based polymer may include a first repeating unit containing a repeating unit represented by Chemical Formula 1 wherein the repeating unit derived from diamine is a functional group represented by Chemical Formula 3; and a second repeating unit containing a repeating unit represented by Chemical Formula 4, wherein the repeating unit derived from diamine is a functional group represented by Chemical Formula 5. The first repeating unit and the second repeating unit can be randomly arranged in the polyimide-based polymer to form a random copolymer, or form a block copolymer by forming a block of the first repeating unit and a block of the second repeating unit.

The polyimide-based polymer including the repeating unit represented by Chemical Formula 1 and the repeating unit represented by Chemical Formula 4 can be prepared by reacting two or more different tetracarboxylic dianhydride compounds with a diamine compound, and the two types of tetracarboxylic dianhydrides can be added simultaneously to synthesize a random copolymer, or can be added sequentially to synthesize a block copolymer.

The polyimide-based resin contains the polyimide repeating unit represented by Chemical Formula 1 in an amount of 20 mol% to 100 mol%, or preferably, 30 mol% to 100 mol%, or 50 mol% to 100 mol%, or 70 mol% to 100 mol% based on 100 mol% of the total repeating unit. Further, the polyimide-based resin may contain the polyimide repeating unit represented by Chemical Formula 4 in an amount of 0 mol% to 80 mol%, or 0 mol% to 70 mol%, or 0 mol% to 50 mol%, or 0 mol% to 30 mol%. The polyimide-based resin film synthesized from the polyimide-based resin within the above-described numerical range can simultaneously satisfy the feature wherein the refractive index difference (Δn) obtained by Equation 1 is 0.0068 or less, and the yellow index at a thickness of 10 µm is 5.5 or less.

Thereby, excellent optical properties of colorless transparency can be realized through a low degree of yellowing, and at the same time, the optical isotropy is increased through the retardation (Rₜₕ) characteristic in the low thickness direction, and the viewing angle of the display to which the polyimide-based resin film is applied is secured, thereby capable of preventing deterioration of visibility due to light distortion phenomenon.

On the other hand, when the polyimide-based resin contains an excessively small amount of the polyimide repeating unit represented by Chemical Formula 1, the thickness direction retardation Rₜₕ value increases to more than 25 nm, and the visibility deteriorates due to the distortion of light due to the increase in the retardation. As the color coordinate b* increases to more than 2, there is a problem that the degree of yellow discoloration increases.

The polyimide repeating unit represented by Chemical Formula 1 and the polyimide repeating unit represented by Chemical Formula 4 may be contained in an amount of 70 mol% or more, or 80 mol% or more, or 90 mol% or more, or 70 mol% or more and 100 mol% or less, 80 mol% or more and 100 mol% or less, 70 mol% or more and 90 mol% or less, 70 mol% or more and 99 mol% or less, 80 mol% or more and 99 mol% or less, 90 mol% or more and 99 mol% or less with respect to the total repeating units contained in the polyimide-based resin.

That is, the polyimide-based resin is composed of only the polyimide repeating unit represented by Chemical Formula 1 and the polyimide repeating unit represented by Chemical Formula 4, or most thereof can be composed of the polyimide repeating unit represented by Chemical Formula 1 and the polyimide repeating unit represented by Chemical Formula 4.

The weight average molecular weight (measured by GPC) of the polyimide-based resin is not particularly limited, but may be, for example, 1000 g/mol or more and 200000 g/mol or less, or 10000 g/mol or more and 200000 g/mol or less.

Because the polyimide-based resin according to the present disclosure can exhibit excellent colorless and transparent properties while maintaining properties such as heat resistance and mechanical strength as they are due to a rigid structure, it can be used in a diverse range of fields such as device substrate, display cover substrate, optical film, integrated circuit (IC) package, adhesive film, multilayer FRC (flexible printed circuit), tape, touch panel, protective polymer film for optical disc, etc. In particular, it can be suitable for display cover substrate.

More specifically, examples of the method of synthesizing the polyimide-based resin film are not particularly limited, and, for example, a method of manufacturing a film including a step of coating a resin composition containing the polyimide-based resin onto a substrate to form a coating film (step 1); a step of drying the coating film (step 2); and a step of heat-treating and curing the dried coating film (step 3) can be used.

Step 1 is a step of coating the resin composition containing the above-mentioned polyimide-based resin onto a substrate to form a coating film. The method of coating the resin composition containing the polyimide-based resin onto a substrate is not particularly limited, and for example, a method such as screen printing, offset printing, flexographic printing, inkjet, and the like can be used.

Further, the resin composition containing the polyimide-based resin may be in the form dissolved or dispersed in an organic solvent. In the case of having such form, for example, when the polyimide-based resin is synthesized in the organic solvent, the solution may be the reaction solution thus obtained itself or a solution obtained by diluting the reaction solution with another solvent. Further, when the polyimide-based resin is obtained as powder, the solution may be a solution obtained by dissolving the powder in an organic solvent.

Specific examples of the organic solvent include N,N-dimethylformamide, N,N-dimethylacetamide, N-methyl-2-pyrrolidone, N-methylcaprolactam, 2-pyrrolidone, N-ethylpyrrolidone, N-vinylpyrrolidone, dimethylsulfoxide, tetramethylurea, pyridine, dimethyl sulfone, hexamethyl sulfoxide, γ-butyrolactone, 3-methoxy-N,N-dimethylpropanamide, 3-ethoxy-N,N-dimethylpropanamide, 3-butoxy-N,N-dimethylpropanamide, 1,3-dimethyl-imidazolidinone, ethyl amyl ketone, methyl nonyl ketone, methyl ethyl ketone, methyl isoamyl ketone, methyl isopropyl ketone, cyclohexanone, ethylene carbonate, propylene carbonate, diglyme, 4-hydroxy-4-methyl-2-pentanone, ethylene glycol monomethyl ether, ethylene glycol monomethyl ether acetate, ethylene glycol monoethyl ether, ethylene glycol monoethyl ether acetate, ethylene glycol monopropyl ether, ethylene glycol monopropyl ether acetate, ethylene glycol monoisopropyl ether, ethylene glycol monoisopropyl ether acetate, ethylene glycol monobutyl ether, ethylene glycol monobutyl ether acetate and the like. They can be used alone or in combination of two or more.

The resin composition containing the polyimide-based resin may include the solid in such an amount that the solution has an appropriate viscosity in consideration of processability such as a coating property during the film forming process. For example, the content of the composition may be adjusted so that the total content of the resin is 5% by weight or more and 25% by weight or less, or may be adjusted to 5% by weight or more and 20% by weight or less, or 5% by weight or more and 15% by weight or less.

In addition, the resin composition containing the polyimide-based resin may further include other components in addition to the organic solvent. In a non-limiting example, when the resin composition containing the polyimide-based resin is coated, additives capable of improving the uniformity of the film thickness and the surface smoothness, or improving the adhesion with a substrate, or changing the dielectric constant and conductivity, or increasing the denseness, may be further included. Examples of these additives include surfactants, silane-based compounds, dielectrics or crosslinking compounds, etc.

Step 2 is a step of drying the coating film formed by coating a resin composition containing the polyimide-based resin onto a substrate.

The step of drying the coating film may be performed by a heating means such as a hot plate, a hot-air circulation furnace, an infrared furnace and the like, and the drying may be performed at a temperature of 50°C or more and 150°C or less, or 50°C or more and 100°C or less.

Step 3 is a step of heat-treating and curing the dried coating film. In this case, the heat treatment may be performed by a heating means such as a hot plate, a hot-air circulation furnace, an infrared furnace and the like, and the heat treatment can be performed at a temperature of 200°C or more, or 200°C or more and 300°C or less.

The thickness of the polyimide-based resin film is not particularly limited, but for example, it can be freely adjusted within the range of 0.01 µm or more and 1000 µm or less. If the thickness of the polyimide-based resin film increases or decreases by a specific value, the physical properties measured in the polyimide-based resin film may also change by a certain numeral value.

Meanwhile, the polyimide-based resin film includes a phosphate-based additive. The phosphate-based additive includes a compound containing a phosphate functional group, and the space between the polyimide main chains can expanded through the bulky structure, thereby realizing high transmittance, low yellow index, and low retardation.

The phosphate-based additive may be contained in an amount of 1% by weight to 50% by weight, or 1% by weight to 40% by weight, or 1% by weight to 30% by weight, or 5% by weight to 50% by weight, or 5% by weight to 40% by weight, or 5% by weight to 30% by weight, or 6% by weight to 30% by weight, or 7% by weight to 30% by weight, or 12% by weight to 30% by weight, or 5% by weight to 25% by weight, or 6% by weight to 25% by weight, or 7% by weight to 25% by weight, or 11% by weight to 25% by weight, or 5% by weight to 18% by weight, or 6% by weight to 18% by weight, or 7% by weight to 18% by weight, or 12% by weight to 18% by weight with respect to the total weight of the polyimide-based resin film.

More specifically, the phosphate-based additive may be added to the resin composition containing the polyimide-based resin for producing the polyimide-based resin film, and can remain even in the polyimide-based resin film. In the resin composition containing the polyimide-based resin, the phosphate-based additive may be contained in an amount of 1% by weight to 50% by weight, or 1% by weight to 40% by weight, or 1% by weight to 30% by weight, or 5% by weight to 50% by weight, or 5% by weight to 40% by weight, or 5% by weight to 30% by weight, or 6% by weight to 30% by weight, or 7% by weight to 30% by weight, or 12% by weight to 30% by weight, or 5% by weight to 25% by weight, or 6% by weight to 25% by weight, or 7% by weight to 25% by weight, or 11% by weight to 25% by weight, or 5% by weight to 18% by weight, or 6% by weight to 18% by weight, or 7% by weight to 18% by weight, or 12% by weight to 18% by weight with respect to total weight of solids.

When the content of the phosphate-based additive is excessively reduced with respect to the total weight of the polyimide-based resin film, it may be difficult to implement a low retardation and high transparency due to the phosphate-based additive. On the other hand, when the content of the phosphate-based additive is excessively increased with respect to the total weight of the polyimide-based resin film, the haze increases and the yellow index also increases, resulting in poor optical properties and poor heat resistance.

The phosphate-based additive includes triaryl phosphate. The triaryl phosphate is a structure in which three aryl groups are bonded to a phosphate functional group, and specific examples of the triaryl phosphate are not particularly limited, and as an example, triphenyl phosphate can be used.

### 2. Substrate for Display Device

Meanwhile, according to another embodiment of the present disclosure, there can be provided a substrate for display device including the polyimide-based resin film of the other embodiment. Details of the polyimide-based resin film may include all of the contents described above in the one embodiment.

The display device including the substrate may include a liquid crystal display device (LCD), an organic light emitting diode (OLED), a flexible display, a rollable display or foldable display, or the like.

The display device may have various structures according to an application field and a specific shape, and may include, for example, a cover plastic window, a touch panel, a polarizing plate, a barrier film, a light emitting device (such as an OLED device), a transparent substrate, or the like.

The polyimide-based resin film of another embodiment described above may be used in various applications such as a substrate, an outer protective film or a cover window in such various display devices, and more specifically, may be applied to a substrate.

For example, the display device substrate may have a structure in which a device protective layer, a transparent electrode layer, a silicon oxide layer, a polyimide-based resin film, a silicon oxide layer, and a hard coating layer are sequentially stacked.

The transparent polyimide substrate may further include a silicon oxide layer formed between the transparent polyimide-based resin film and the cured layer in order to further improve the solvent resistance, water permeability and optical properties thereof, and the silicon oxide layer may be produced by curing polysilazane.

Specifically, the silicon oxide layer may, before forming a coating layer on at least one surface of the transparent polyimide-based resin film, be formed by curing the coated polysilazane after coating and drying a solution containing polysilazane

The substrate for a display device according to the present disclosure can provide a transparent polyimide cover substrate having solvent resistance, optical properties, water permeability and scratch resistance while having excellent bow properties and impact resistance by including the above-mentioned device protective layer.

### 3. Optical Device

Meanwhile, according to another embodiment of the present disclosure, there can be provided an optical device including the polyimide-based resin film of the other embodiment. Details of the polyimide-based resin film may include all of those described above in the one embodiment.

The optical device may include all kinds of devices using properties realized by light, and may be, for example, a display device. Specific examples of the display device include a liquid crystal display device (LCD), an organic light emitting diode (OLED), a flexible display, a rollable display or foldable display device, or the like, but is not limited thereto.

The optical device may have various structures according to the application field and the specific shape, and for example, it may have a structure including a cover plastic window, a touch panel, a polarizing plate, a barrier film, a light emitting device (such as an OLED device), a transparent substrate, or the like.

The polyimide-based resin film of another embodiment described above may be used in various applications such as a substrate, an outer protective film or a cover window in various optical devices, and more specifically, may be applied to a substrate.

### [Advantageous Effects]

According to the present disclosure, a polyimide-based resin film that has low birefringence by increasing light transmittance through low yellow index and significantly improved transparency, and thus, is suitable for use as an optical member, and at the same time, the optical isotropy is increased through a low refractive index difference (Δn) characteristic to realize a low retardation, and a diagonal viewing angle of the display to which the polyimide-based resin film is applied is secured, thereby preventing deterioration of visibility due to light distortion phenomenon, a substrate for display device, and an optical device using the same can be provided.

### [DETAILED DESCRIPTION OF THE EMBODIMENTS]

Hereinafter, embodiments of the present disclosure will be described in more detail by way of examples. However, these examples are provided for illustrative purposes only, and are not intended to limit the scope of the present disclosure.

### <Example and Comparative Example: Preparation of polyimide precursor composition and polyimide film>

### Example 1

### (1) Preparation of polyimide precursor composition

The organic solvent DEAc was filled in a reactor under a stream of nitrogen, and then m-phenylenediamine (1,3-phenylenediamine, m-PDA) was added and dissolved at the same temperature while maintaining the temperature of the reactor to 25°C. To the solution to which the m-phenylenediamine (1,3-phenylenediamine, m-PDA) was added, 4,4'-oxydiphthalic anhydride (ODPA) was added as an acid dianhydride at the same temperature, and stirred for 24 hours. At this time, the molar ratios of m-PDA and OPDA are as shown in Table 1 below.

Then, triphenyl phosphate (TPhP) was added in an amount of 15% by weight based on the total solid content and stirred to prepare a polyimide precursor composition.

### (2) Preparation of Polyimide Film

The polyimide precursor composition was spin-coated on a glass substrate. The curing process was performed by maintaining the glass substrate coated with the polyimide precursor composition at 80°C for 5 to 30 minutes and at 260°C for 60 minutes. After completion of the curing process, the glass substrate was immersed in water to peel off the film formed on the glass substrate, and dried in an oven at 100°C to prepare a polyimide film having a thickness of 10 µm (including an error of ±1 µm).

### Examples 2~5, Comparative Example 1

A polyimide precursor composition and a polyimide film were prepared in the same manner as in Example 1, except that the molar ratio of m-PDA, OPDA, and TPhP content were changed as shown in Table 1 below.

### Example 6

### (1) Preparation of polyimide precursor composition

The organic solvent DEAc was filled in a reactor under a stream of nitrogen, and then m-phenylenediamine (1,3-phenylenediamine, m-PDA) and 4,4'-oxydianiline (ODA) were added and dissolved at the same temperature while maintaining the temperature of the reactor to 25°C. To the solution to which m-phenylenediamine (1,3-phenylenediamine, m-PDA) and 4,4'-oxydianiline (ODA) were added, 4,4'-oxydiphthalic anhydride (ODPA) was added as an acid dianhydride at the same temperature, and stirred for 24 hours. At this time, the molar ratios of m-PDA, ODA, and OPDA are as shown in Table 2 below.

Then, triphenyl phosphate (TPhP) was added in an amount of 10% by weight with respect to the total solid content, and stirred to prepare a polyimide precursor composition.

### (2) Preparation of Polyimide Film

The polyimide precursor composition was spin-coated on a glass substrate. The curing process was performed by maintaining the glass substrate coated with the polyimide precursor composition at 80°C for 5 to 30 minutes and at 260°C for 60 minutes. After completion of the curing process, the glass substrate was immersed in water to peel off the film formed on the glass substrate, and dried in an oven at 100°C to prepare a polyimide film having a thickness of 10 µm (including an error of ±1 µm).

### Examples 7~10, Comparative Example 2

A polyimide precursor composition and a polyimide film were prepared in the same manner as in Example 6, except that the molar ratio of m-PDA, ODA, OPDA, and TPhP content were changed as shown in Table 2 below.

### Comparative Examples 3~7

A polyimide precursor composition and a polyimide film were prepared in the same manner as in Example 6, except that the molar ratio of m-PDA, p-PDA (1,4-phenylenediamine), ODA, OPDA, BPDA (3,3',4,4'-biphenyltetracarboxylic dianhydride), PMDA (pyromellitic dianhydride), and TPhP content were changed as shown in Table 3 below.

### <Experimental Example: Measurement of Physical Properties of Polyimide Precursor Composition and Polyimide Films Obtained in Examples and Comparative Examples>

The physical properties of the polyimide precursor composition and the polyimide films obtained in Examples and Comparative Examples were measured by the following methods, and the results are shown in Tables 1 to 3 below.

### 1. Yellow index (YI), Color Coordinates (b*)

The yellow index and the color coordinates (b*) of the polyimide films prepared in Examples and Comparative Examples were measured using a color meter (Color-Eye 7000A produced by GRETAGMACBETH), and are shown in Table 1 below.

### 2. Thickness Direction Retardation (Rₜₕ)

The value of the refractive index of the polyimide film prepared in Examples and Comparative Examples with respect to light at 532 nm was input using the trade name "AxoScan" produced by AXOMETRICS as a measuring device, and then the retardation in the thickness direction and in the plane direction was measured using light with a wavelength of 532 nm under conditions of temperature: 25°C and humidity: 40%. The obtained retardation measured value in the thickness direction (measured value by automatic measurement of the measuring device) was converted into a retardation value per 10 µm of film thickness, and shown in Table 1 below.

Specifically, the thickness direction retardation Rₜₕ was calculated according to the following Equation 2. ${R}_{th} \left(nm\right) = \left|\left[\left({n}_{x}+{n}_{y}\right)/2\right]-{n}_{z}\right| \times d$ wherein, in Equation 2, nₓ is the largest refractive index among in-plane refractive indices of the polyimide resin film measured with light having a wavelength of 532 nm; n_{y} is a refractive index perpendicular to nₓ among in-plane refractive indices of the polyimide resin film measured with light having a wavelength of 532 nm; n_{z} is the thickness direction refractive index of the polyimide resin film measured with light having a wavelength of 532 nm; and d is the thickness of the polyimide-based resin film.

### 3. Refractive Index

The plane direction (TE) and thickness direction (TM) refractive indices of the polyimide films prepared in Examples and Comparative Examples were measured at a wavelength of 532 nm using a prism coupler, and then the average refractive index was calculated according to the following Equation 3. $Average refractive index = \left({n}_{x}+{n}_{y}+{n}_{z}\right) / 3$ wherein, in Equation 3, nₓ is the largest refractive index among in-plane refractive indices of the polyimide resin film measured with light having a wavelength of 532 nm; n_{y} is a refractive index perpendicular to nₓ among in-plane refractive indices of the polyimide resin film measured with light having a wavelength of 532 nm; and n_{z} is the thickness direction refractive index of the polyimide resin film measured with light having a wavelength of 532 nm.

### 4. Haze

The haze value of the polyimide film was measured using a Hazemeter (NDH-5000), and evaluated under the following criteria.

**[Table 1]**

| Experimental Example Measurement Results of Examples 1-5 and Comparative Example 1 | | | | | | |
|---|---|---|---|---|---|---|
| Category | Example 1 | Example 2 | Example 3 | Example 4 | Example 5 | Comparativ e Example 1 |
| Molar ratio of monomers | 100/99.8 (ODPA/ m-PDA) | 100/99.8 (ODPA/ m-PDA) | 100/99.8 (ODPA/ m-PDA) | 100/99.8 (ODPA/ m-PDA) | 100/99.8 (ODPA/ m-PDA) | 100/99.8 (ODPA/m-PDA) |
| TPhP (wt%) | 15 | 5 | 6.5 | 10 | 20 | 0 |
| Content of solids(%) | 13.25 | 13.25 | 13.25 | 13.25 | 13.25 | 13.25 |
| b* | 1.24 | 3.60 | 3.02 | 1.89 | 1.19 | 6.04 |
| YI | 2.18 | 5.23 | 4.32 | 2.92 | 1.91 | 9.58 |
| HAZE(%) | 0.5 | 0.32 | 0.45 | 0.42 | 0.54 | 0.24 |
| Rₜₕ (nm) | 35 | 35 | 20 | 26 | 34 | 60 |
| Plane direction refractive index(nTE)@532n m | 1.7058 | 1.7066 | 1.7053 | 1.7039 | 1.7042 | 1.7105 |
| Thickness direction refractive index(nTM)@532n m | 1.7016 | 1.7029 | 1.7008 | 1.7005 | 1.7001 | 1.7029 |
| Refractive index difference (nTE-nTM) @532nm | 0.0042 | 0.0037 | 0.0045 | 0.0034 | 0.0041 | 0.0076 |
| Average refractive index@532nm | 1.7044 | 1.7058 | 1.7038 | 1.7028 | 1.7028 | 1.708 |

As shown in Table 1, it was confirmed that the polyimide films (based on a thickness of 10 µm) obtained in Examples 1 to 5 has the thickness direction retardation Rₜₕ value of 20 nm to 35 nm, the color coordinate b* of 1.19 to 3.60, YI of 1.91 to 5.23, the refractive index difference (nTE-nTM) at 532 nm of 0.0034 to 0.0045, and the average refractive index at 532 nm of 1.7028 to 1.7058. On the other hand, in the case of the polyimide film (based on a thickness of 10 µm) obtained in Comparative Example 1, the thickness direction retardation Rₜₕ value is 60 nm, which is increased compared to Examples 1 to 5 and thus make it difficult to express visibility suitable for a display, the color coordinate b* is 6.04 and YI is 9.58, which are higher than in Examples 1 to 5, and thus there is a limit in that a color distortion phenomenon occurred. In addition, it was confirmed that the refractive index difference (nTE-nTM) at 532 nm is 0.0076, and the average refractive index at 532 nm is 1.708, which is increased compared to Examples 1 to 5, and shows a higher retardation.

**[Table 2]**

| Experimental Example Measurement Results of Examples 6-10 and Comparative Example 2 | | | | | | |
|---|---|---|---|---|---|---|
| Category | Example 6 | Example 7 | Example 8 | Example 9 | Example 10 | Comparati ve Example 2 |
| Molar ratio of monomers | 100/70/29 .8 (ODPA/m - PDA/OD A) | 100/70/29 .8 (ODPA/m - PDA/OD A) | 100/70/29 .8 (ODPA/m - PDA/OD A) | 100/70/29 .8 (ODPA/m - PDA/OD A) | 100/29.8/ 70 (ODPA/m - PDA/OD A) | 100/70/29. 8 (ODPA/m-PDA/ODA ) |
| TPhP (wt%) | 10 | 5 | 6.5 | 20 | 5 | 0 |
| Content of solids(%) | 13.25 | 13.25 | 13.25 | 13.25 | 13.25 | 13.25 |
| b* | 2.04 | 2.61 | 2.52 | 1.62 | 2.95 | 4.98 |
| YI | 3.37 | 4.16 | 4.1 | 3.03 | 3.69 | 8.24 |
| Rₜₕ (nm) | 44 | 28 | 27 | 52 | 43 | 73 |
| Plane direction | 1.7024 | 1.7042 | 1.7036 | 1.7019 | 1.7026 | 1.7083 |
| refractive index(nTE)@532 nm | | | | | | |
| Thickness direction refractive index(nTM)@532 nm | 1.6962 | 1.6993 | 1.6992 | 1.6957 | 1.6959 | 1.6983 |
| Refractive index difference (nTE-nTM)@532nm | 0.0062 | 0.0049 | 0.0044 | 0.0062 | 0.0067 | 0.0100 |
| Average refractive index@532nm | 1.7003 | 1.7026 | 1.7021 | 1.6998 | 1.7004 | 1.7056 |

As shown in Table 2, it was confirmed that the polyimide films (based on a thickness of 10 µm) obtained in Examples 6 to 10 has the thickness direction retardation Rₜₕ value of 27 nm to 52 nm, the color coordinate b* of 1.62 to 2.95, YI of 3.03 to 4.16, the refractive index difference (nTE-nTM) at 532 nm of 0.0044 to 0.0067, and the average refractive index at 532 nm of 1.6998 to 1.7026. On the other hand, in the case of the polyimide film (based on a thickness of 10 µm) obtained in Comparative Example 2, the thickness direction retardation Rₜₕ value is 73 nm, which is increased compared to Examples 6 to 10 and thus make it difficult to express visibility suitable for a display, the color coordinate b* is 4.98 and YI is 8.24, which are higher than in Examples 1 to 5, and thus there is a limit in that a color distortion phenomenon occurred. In addition, it was confirmed that the refractive index difference (nTE-nTM) at 532 nm is 0.0100, and the average refractive index at 532 nm is 1.7056, which is increased compared to Examples 6 to 10, and shows a higher retardation.

**[Table 3]**

| Experimental Example Measurement Results of Comparative Examples 3~7 | | | | | |
|---|---|---|---|---|---|
| Category | Comparativ e Example 3 | Comparativ e Example 4 | Comparativ e Example 5 | Comparativ e Example 6 | Comparative Example 7 |
| Molar ratio of monomers | 100/0/99.8 (ODPA/m-PDA/ODA) | 100/29.8/70 (ODPA/m-PDA/ODA) | 100/0/99.8 (ODPA/m-PDA/ODA) | 100/29.8/70 (BPDA/m-PDA/p-PDA) | 100/99.8 (PMDA/ODA ) |
| TPhP (wt%) | 0 | 0 | 5 | 5 | 5 |
| Content of solids(%) | 13.25 | 13.25 | 13.25 | 12.22 | 9.95 |
| b* | 3.83 | 3.83 | 3.32 | 11.44 | 61.15 |
| YI | 5.69 | 6.46 | 4.37 | 17.41 | 81 |
| Rₜₕ (nm) | 98 | 93 | 53 | 1024 | 646 |
| Plane direction refractive index(nTE)@532n m | 1.7062 | 1.7062 | 1.7016 | 1.7959 | 1.7327 |
| Thickness direction refractive index(nTM)@532n m | 1.6941 | 1.6949 | 1.6947 | 1.7036 | 1.6684 |
| Refractive index difference (nTE-nTM)@532nm | 0.0121 | 0.0113 | 0.0069 | 0.0923 | 0.0643 |
| Average refractive index@532nm | 1.7022 | 1.7024 | 1.6993 | 1.7657 | 1.7115 |

As shown in Table 3, it was confirmed that the polyimide films (based on a thickness of 10 µm) obtained in Comparative Examples 3 to 5 has the thickness direction retardation Rₜₕ value of 53 nm to 98 nm, the color coordinate b* of 3.32 to 3.83, YI of 4.37 to 6.46, the refractive index difference (nTE-nTM) at 532 nm of 0.0069 to 0.0121, and the average refractive index at 532 nm of 1.6993 to 1.7024. In addition, it was confirmed that the polyimide films (based on a thickness of 10 µm) obtained in Comparative Examples 6 to 7 has the thickness direction retardation Rₜₕ value of 646 nm to 1024 nm, the color coordinate b* of 11.44 to 61.15, YI of 17.41 to 81, the refractive index difference (nTE-nTM) at 532 nm of 0.0643 to 0.0923, and the average refractive index at 532 nm of 1.7115 to 1.7657.

That is, it was confirmed that in the case of Comparative Examples 3 to 7, the thickness direction retardation Rₜₕ value is increased compared to Examples 1 to 10 and thus make it difficult to express visibility suitable for a display, and the refractive index difference (nTE-nTM) at 532 nm is increased compared to Examples 1 to 10, and shows a higher retardation.

## Claims

1. A polyimide-based resin film in which a refractive index difference (Δn) obtained by the following Equation 1 is 0.0068 or less, and a yellow index at a thickness of 10 µm is 5.5 or less as measured using a color meter: $Refractive Index Difference \left(Δn\right) = n 1 - n 2$
wherein, in Equation 1, n1 is a plane direction refractive index value of the polyimide-based resin film at a thickness of 10 µm, and n2 is a thickness direction refractive index value of the polyimide-based resin film at a thickness of 10 µm as both measured at a wavelength of 532 nm using a prism coupler,
wherein the polyimide-based resin film includes a polyimide-based resin containing a polyimide repeating unit represented by the following Chemical Formula 1 in an amount of 20 mol% to 100 mol% based on 100 mol% of the total repeating unit: 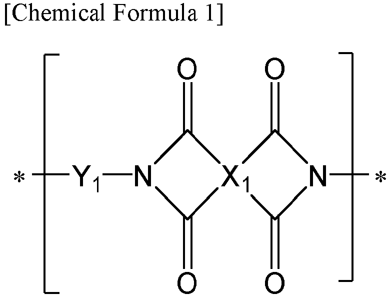
wherein, in Chemical Formula 1,
X₁ includes a tetravalent functional group represented by the following Chemical Formula 2: 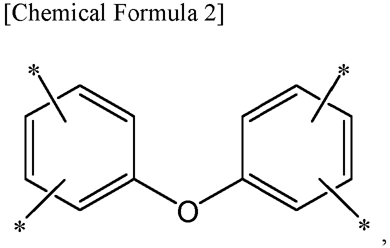 and
Y₁ includes a functional group represented by the following Chemical Formula 3-1: 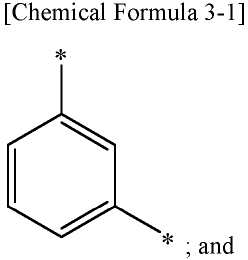
wherein the polyimide-based resin film includes a triaryl phosphate.

2. The polyimide-based resin film of claim 1, wherein:
the polyimide-based resin film has a color coordinate b* at a thickness of 10 µm of 1 to 4 as measured using a color meter.

3. The polyimide-based resin film of claim 1, wherein:
the polyimide-based resin film has a thickness direction retardation Rₜₕ value at a thickness of 10 µm of 10 nm to 52 nm measured as described in the specifiation.

4. The polyimide-based resin film of claim 1, wherein:
the polyimide-based resin film has an average refractive index at a wavelength of 532 nm of 1.6995 to 1.7060.

5. The polyimide-based resin film of claim 1, wherein:
the polyimide-based resin film has a plane direction refractive index at a wavelength of 532 nm of 1.70 to 1.71.

6. The polyimide-based resin film of claim 1, wherein:
the polyimide-based resin film has a thickness direction refractive index at a wavelength of 532 nm of 1.69 to 1.71.

7. The polyimide-based resin film of claim 1, wherein:
the polyimide-based resin film has a haze value of less than 1.0% as measured using a hazemeter.

8. The polyimide-based resin film of claim 1, wherein:
the polyimide-based resin further includes a polyimide repeating unit represented by the following Chemical Formula 4 in addition to the polyimide repeating unit represented by Chemical Formula 1: 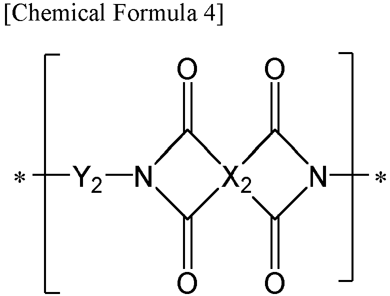
wherein, in Chemical Formula 4,
X₂ is an aromatic tetravalent functional group containing an ether group, and
Y₂ is an aromatic divalent functional group containing an ether group and having 12 to 17 carbon atoms.

9. A substrate for display device comprising the polyimide-based resin film of claim 1.

10. An optical device comprising the polyimide-based resin film of claim 1.

## Patentansprüche

1. Harzfilm auf Basis von Polyimid, in dem eine Brechungsindexdifferenz (Δn), die durch die folgende Gleichung 1 erhalten wird, 0,0068 oder weniger beträgt und ein Gelbindex bei einer Dicke von 10 µm 5,5 oder weniger beträgt, gemessen unter Verwendung eines Farbmessgeräts: $Brechungsindexdifferenz \left(Δn\right) = n 1 - n 2$
wobei in Gleichung 1 n1 ein Brechungsindexwert in Ebenenrichtung des Harzfilms auf Basis von Polyimid bei einer Dicke von 10 µm ist und n2 ein Brechungsindexwert in Dickenrichtung des Harzfilms auf Basis von Polyimid bei einer Dicke von 10 µm ist, beide gemessen bei einer Wellenlänge von 532 nm unter Verwendung eines Prismenkopplers,
wobei der Harzfilm auf Basis von Polyimid ein Harz auf Basis von Polyimid enthält, das eine durch die folgende chemische Formel 1 dargestellte Polyimid-Wiederholungseinheit in einer Menge von 20 Mol-% bis 100 Mol-%, bezogen auf 100 Mol-% der gesamten Wiederholungseinheit, enthält: 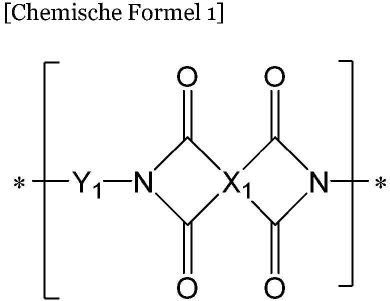
wobei in der chemischen Formel 1
X₁ eine durch die folgende chemische Formel 2 dargestellte vierwertige funktionelle Gruppe enthält: 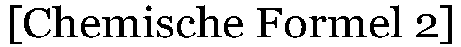 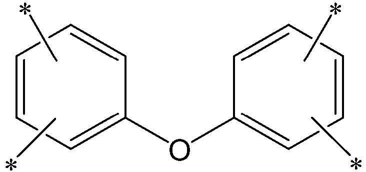 und
Y₁ eine durch die folgende chemische Formel 3-1 dargestellte funktionelle Gruppe enthält: 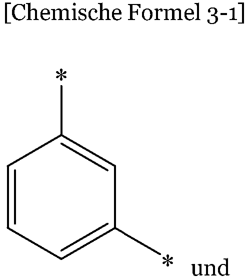
wobei der Harzfilm auf Basis von Polyimid ein Triarylphosphat enthält.

2. Harzfilm auf Basis von Polyimid nach Anspruch 1, bei dem:
der Harzfilm auf Basis von Polyimid eine Farbkoordinate b* bei einer Dicke von 10 µm von 1 bis 4 aufweist, gemessen unter Verwendung eines Farbmessgeräts.

3. Harzfilm auf Basis von Polyimid nach Anspruch 1, bei dem:
der Harzfilm auf Basis von Polyimid einen Verzögerungswert Rₜₕ in Dickenrichtung bei einer Dicke von 10 µm von 10 nm bis 52 nm aufweist, gemessen wie in der Beschreibung beschrieben.

4. Harzfilm auf Basis von Polyimid nach Anspruch 1, bei dem:
der Harzfilm auf Basis von Polyimid einen durchschnittlichen Brechungsindex bei einer Wellenlänge von 532 nm von 1,6995 bis 1,7060 aufweist.

5. Harzfilm auf Basis von Polyimid nach Anspruch 1, bei dem:
der Harzfilm auf Basis von Polyimid einen Brechungsindex in Ebenenrichtung bei einer Wellenlänge von 532 nm von 1,70 bis 1,71 aufweist.

6. Harzfilm auf Basis von Polyimid nach Anspruch 1, bei dem:
der Harzfilm auf Basis von Polyimid einen Brechungsindex in Dickenrichtung bei einer Wellenlänge von 532 nm von 1,69 bis 1,71 aufweist.

7. Harzfilm auf Basis von Polyimid nach Anspruch 1, bei dem:
der Harzfilm auf Basis von Polyimid einen Trübungswert von weniger als 1,0 % aufweist, gemessen unter Verwendung eines Trübungsmessgeräts.

8. Harzfilm auf Basis von Polyimid nach Anspruch 1, bei dem:
das Harz auf Basis von Polyimid ferner eine durch die folgende chemische Formel 4 dargestellte Polyimid-Wiederholungseinheit zusätzlich zu der durch die chemische Formel 1 dargestellten Polyimid-Wiederholungseinheit enthält: 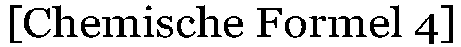 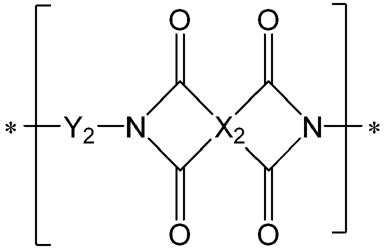
wobei in der chemischen Formel 4
X₂ eine aromatische vierwertige funktionelle Gruppe ist, die eine Ethergruppe enthält, und
Y₂ eine aromatische zweiwertige funktionelle Gruppe ist, die eine Ethergruppe enthält und 12 bis 17 Kohlenstoffatome aufweist.

9. Substrat für eine Anzeigevorrichtung, umfassend den Harzfilm auf Basis von Polyimid nach Anspruch 1.

10. Optische Vorrichtung, umfassend den Harzfilm auf Basis von Polyimid nach Anspruch 1.

## Revendications

1. Film de résine à base de polyimide dans lequel une différence d'indice de réfraction (Δn) obtenue par l'Équation 1 ci-après est égale ou inférieure à 0,0068, et un indice de jaunissement à une épaisseur de 10 µm est égal ou inférieur à 5,5, mesuré en utilisant un colorimètre : $Différence d ′ indice de réfraction \left(Δn\right) = n 1 - n 2$
dans lequel, dans l'Équation 1, n1 est une valeur d'indice de réfraction dans la direction du plan du film de résine à base de polyimide à une épaisseur de 10 µm, et n2 est une valeur d'indice de réfraction dans la direction d'épaisseur du film de résine à base de polyimide à une épaisseur de 10 µm, tous deux mesurés à une longueur d'onde de 532 nm en utilisant un coupleur à prisme,
dans lequel le film de résine à base de polyimide inclut une résine à base de polyimide contenant une unité de répétition de polyimide représentée par la Formule chimique 1 ci-après dans une quantité de 20 % en moles à 100 % en moles sur la base de 100 % en moles de l'unité de répétition totale : 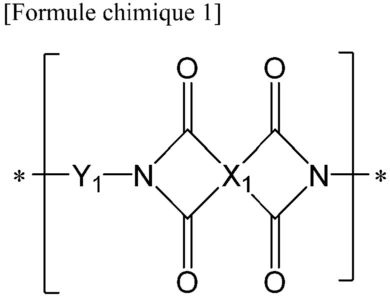
dans lequel, dans la Formule chimique 1,
X₁ inclut un groupe fonctionnel tétravalent représenté par la Formule chimique 2 ci-après : 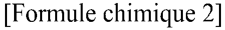 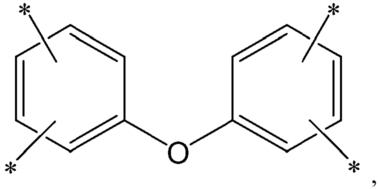 et
Y₁ inclut un groupe fonctionnel représenté par la Formule chimique 3-1 ci-après : 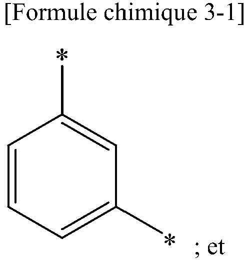
dans lequel le film de résine à base de polyimide inclut un phosphate de triaryle.

2. Film de résine à base de polyimide selon la revendication 1, dans lequel :
le film de résine à base de polyimide a une coordonnée de couleur b* à une épaisseur de 10 µm de 1 à 4, mesurée en utilisant un colorimètre.

3. Film de résine à base de polyimide selon la revendication 1, dans lequel :
le film de résine à base de polyimide a une valeur de retard Rₜₕ dans une direction d'épaisseur à une épaisseur de 10 µm de 10 nm à 52 nm, mesurée comme décrit dans la spécification.

4. Film de résine à base de polyimide selon la revendication 1, dans lequel :
le film de résine à base de polyimide a un indice de réfraction moyen à une longueur d'onde de 532 nm de 1,6995 à 1,7060.

5. Film de résine à base de polyimide selon la revendication 1, dans lequel :
le film de résine à base de polyimide a un indice de réfraction dans la direction du plan à une longueur d'onde de 532 nm de 1,70 à 1,71.

6. Film de résine à base de polyimide selon la revendication 1, dans lequel :
le film de résine à base de polyimide a un indice de réfraction dans la direction d'épaisseur à une longueur d'onde de 532 nm de 1,69 à 1,71.

7. Film de résine à base de polyimide selon la revendication 1, dans lequel :
le film de résine à base de polyimide a une valeur de voile inférieure à 1,0 %, mesurée en utilisant un dispositif de mesure de voile.

8. Film de résine à base de polyimide selon la revendication 1, dans lequel :
le film de résine à base de polyimide inclut en outre une unité de répétition de polyimide représentée par la Formule chimique 4 ci-après en plus de l'unité de répétition de polyimide représentée par la Formule chimique 1 : 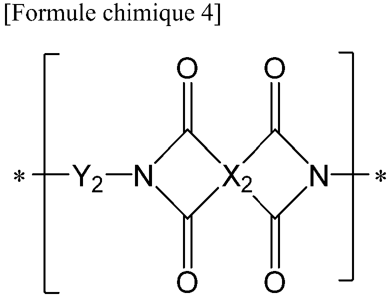
dans lequel, dans la Formule chimique 4,
X₂ est un groupe fonctionnel tétravalent aromatique contenant un groupe éther, et
Y₂ est un groupe fonctionnel divalent aromatique contenant un groupe éther et ayant 12 à 17 atomes de carbone.

9. Substrat pour un dispositif d'affichage comprenant le film de résine à base de polyimide selon la revendication 1,

10. Dispositif optique comprenant le film de résine à base de polyimide selon la revendication 1,
